# EUROPEAN PATENT SPECIFICATION

(11) **EP 3 968 378 B1**
(45) Date of publication and mention of the grant of the patent: **08.11.2023**
(21) Application number: 20815418.7
(22) Date of filing: 07.05.2020
(51) Int. Cl.: H01L 27/146

(54) **COMPLEMENTARY METAL OXIDE IMAGE SENSOR, IMAGE PROCESSING METHOD, AND STORAGE MEDIUM**
KOMPLEMENTÄRER METALLOXIDBILDSENSOR, BILDVERARBEITUNGSVERFAHREN UND SPEICHERMEDIUM
CAPTEUR D'IMAGE À OXYDE MÉTALLIQUE COMPLÉMENTAIRE, PROCÉDÉ DE TRAITEMENT D'IMAGE ET SUPPORT D'INFORMATIONS

(30) Priority: 31.05.2019 CN 201910472468
(43) Date of publication of application: 16.03.2022
(73) Proprietor: GUANGDONG OPPO MOBILE TELECOMMUNICATIONS CORP., LTD., Dongguan, Guangdong 523860 (CN)
(72) Inventor: YANG, Xin, Dongguan, Guangdong 523860 (CN)
(74) Representative: Penza, Giancarlo
(86) International application number: PCT/CN2020/089059
(87) International publication number: WO 2020/238576

(56) References cited:
- EP-A1- 3 985 729
- US-A1- 2018 269 245

## Description

This application is based on a Chinese patent application No. 201910472468.3 filed on May 31, 2019, and claims priority to the Chinese patent application.

### TECHNICAL FIELD

Embodiments of the present disclosure relate to the field of image processing, and particularly to a Complementary Metal-Oxide Semiconductor image sensor, an image processing method, and a storage medium. The invention is set out in the appended set of claims.

### BACKGROUND

At present, the Complementary Metal-Oxide Semiconductor image sensor (CMOS Image Sensor, CIS) generally absorbs red, green and blue (RGB) light through a color filter provided with a color filter array of a particular arrangement, to produce color images. For example, a Bayer filter is equipped in the CIS. Based on different arrangements, the color filters are classified into different types, such as RGBG, GRGB and RGGB. Further, in order to avoid the low light efficiency of the color filters such as the RGBG, GRGB and RGGB color filters, other types of color filters, such as Red-White-White-Blue (RWWB) or Red-Yellow-Yellow-Blue (RYYB), are gradually used.

However, in the case where the RYYB or RWWB color filters are used to produce color images, since the amount of light into the Y channel or the W channel is higher than the amount of light into each of the R channel and the B channel, there is a problem that the R and B pixels are still unsaturated when the Y or W pixels are saturated, resulting in waste of signals in the R and B channels.

US2018/0269245A1 discloses an image sensor, including pixels having nested sub-pixels. A pixel with nested sub-pixels may include an inner sub-pixel that has either an elliptical or a rectangular light collecting area. The inner sub-pixel may be formed in a substrate and may be immediately surrounded by a sub-pixel group that includes one or more sub-pixels. The inner sub-pixel may have a light collecting area at a surface that is less sensitive than the light collecting area of the one or more outer sub-pixel groups. Micro-lenses may be formed over the nested sub-pixels, to direct light away from the inner sub-pixel group to the outer sub-pixel groups in nested sub-pixels. A color filter of a single color may be formed over the nested sub-pixels. Hybrid color filters having a single color filter region over the inner sub-pixel and a portion of the one or more outer sub-pixel groups may also be used.

### SUMMARY

The embodiments of the present disclosure provide a Complementary Metal-Oxide Semiconductor image sensor, an image processing method, and a storage medium, by which different types of pixels are enabled to reach saturation at the same time, information of each channel can be fully utilized, and the efficiency of the CIS is significantly improved. The invention is set out in the appended set of claims.

The embodiments of the disclosure provide a Complementary Metal-Oxide Semiconductor image sensor, an image processing method, and a storage medium. The CIS includes a color filter and a sub-wavelength pixel unit. The color filter includes a first light filter unit corresponding to a first wavelength range, a second light filter unit corresponding to a second wavelength range, and a third light filter unit corresponding to a third wavelength range. The sub-wavelength pixel unit includes a first PD column unit corresponding to the first wavelength range, a second PD column unit corresponding to the second wavelength range, and a third PD column unit corresponding to the third wavelength range. A first light-receiving surface of the first PD column unit, a second light-receiving surface of the second PD column unit, and a third light-receiving surface of the third PD column unit have equal area. First junction area of the first PD column unit, second junction area of the second PD column unit, and third junction area of the third PD column unit are not equal. As can be seen, in the embodiments of the present disclosure, the color filter and sub-wavelength pixel unit provided for the CIS are incorporated with light filter units and PD column units which correspond to different wavelength ranges, to select and absorb light in different wavelength ranges. In addition, the various PD column units corresponding to light of different wavelength ranges have light-receiving surfaces of equal area, but they have unequal junction area, therefore, the different PD column units corresponding to light of different wavelength ranges have different full well capacities. Accordingly, the different types of pixels can reach saturation at the same time, making full use of the information of each channel, and greatly improving the efficiency of the CIS.

### BRIEF DESCRIPTION OF THE DRAWINGS

FIG. 1 is a schematic diagram of an FSI-type CIS;
FIG. 2 is a schematic diagram of a BSI- type CIS;
FIG. 3 is a schematic diagram of a CIS equipped with a RYYB color filter;
FIG. 4 is a schematic structural diagram of a CIS provided by the embodiments of the disclosure;
FIG. 5 is a schematic diagram of a RWWB color filter;
FIG. 6 is a schematic diagram illustrating R and W channels;
FIG. 7 is a schematic diagram illustrating a circuit of the R channel;
FIG. 8 is a schematic diagram illustrating a circuit of the W channel; and
FIG. 9 is an image processing method provided by the embodiments of the disclosure.

### DETAILED DESCRIPTION OF PREFERRED EMBODIMENTS

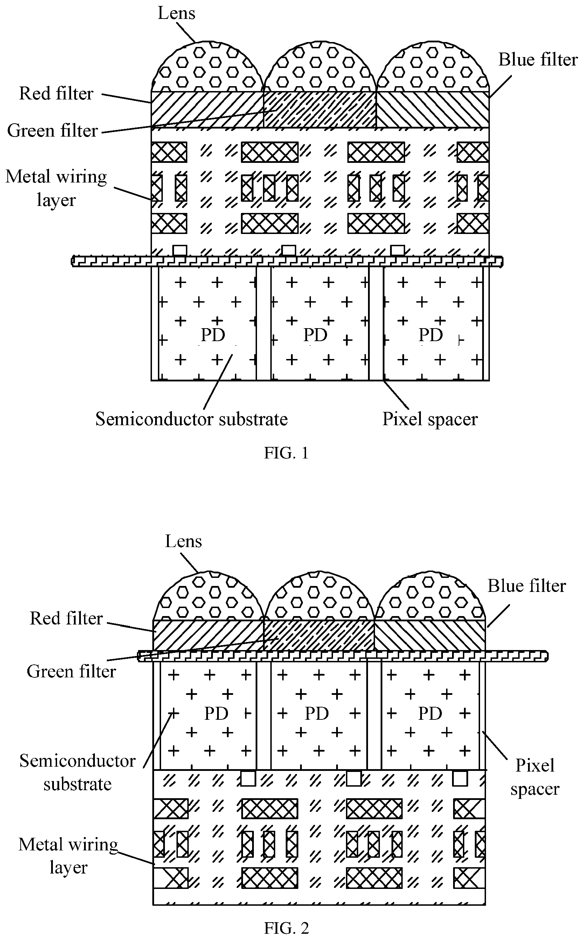

The technical solutions in the embodiments of the present disclosure will be clearly and completely described below in conjunction with the drawings in the embodiments of the present disclosure. It is understandable that, the specific embodiments described here are only used to explain the disclosure, but not to limit it. In addition, it should be noted that only parts related to the disclosure are shown in the drawings, for ease of description. The following embodiments of FIGS. 1-3 and 5 are embodiments not covered by the claimed invention and thus are to be considered merely as examples suitable for understanding the invention.

An image sensor is capable of converting an optical signal into an electrical signal. There are two types of image sensors: Charge Coupled Device (CCD) image sensors, and Complementary Metal-Oxide Semiconductor (CMOS) image sensors. Among them, the manufacturing process of the CISs is compatible with the manufacturing processes of signal processing chips, and the CISs can be easily integrated on the system-on-chip. In addition, the CISs have a significantly lower power consumption compared with the CCD image sensors, and the image de-noising algorithm thereof can improve the signal-to-noise ratio. Therefore, the CISs prevail in the field of image sensors.

The CISs have two different structures: Front Side Illumination (FSI), and Back Side Illumination (BSI). For the related CISs, whether being FSI or BSI, the photodiodes (PD) therein absorb all the incident light. Therefore, a color filter needs to be provided in the CISs to make different pixels absorb light of different colors. FIG. 1 is a schematic diagram of an FSI-type CIS, and FIG. 2 is a schematic diagram of a BSI-type CIS. As shown in FIG. 1 and FIG. 2, the CIS includes a semiconductor substrate, PDs, a red filter, a green filter, a blue filter, a pixel spacer, and metal wiring layers. In addition, a lens may also be provided before each filter.

Bayer filter is a mosaic-like color filter array formed by arranging RGB color filters on a grid of light sensor components. Most of the digital image sensors in the single chips used in the digital cameras, video recorders, scanners and the like adopt this color filter array of a particular arrangement to produce color images. In the arrangement of this color filter array, green filters accounts for 50%, red filters accounts for 25%, and blue filters accounts for 25%. Specifically, the Bayer filter may have different types such as RGBG, GRGB, and RGGB.

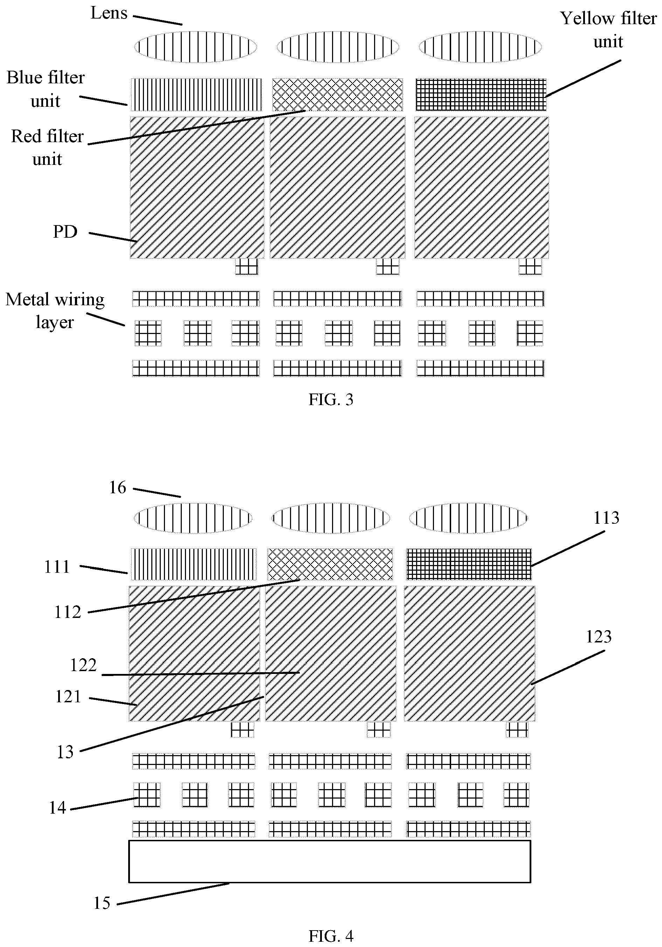

At present, since the RGBG, GRGB and RGGB color filters have relatively low light efficiency, other types of color filters, such as RWWB, RYYB, cyan-magenta-yellow (CMY), can be used for color imaging. However, in the RYYB or RWWB color filter, there is a problem that the R and B pixels are still unsaturated when the Y or W pixels are saturated. FIG. 3 is a schematic diagram of a CIS equipped with a RYYB color filter. As shown in FIG. 3, the color filter includes a blue filter unit, a red filter unit, and a yellow filter unit. The PDs corresponding to the R, B, and Y channels have a same full well capacity, that is, when any of the pixels is saturated, the intensity of light received thereof is the same. However, the amount of light into the Y channel is higher than that of the R channel and the W channel. Therefore, when the Y channel is saturated, the R channel and the B channel are still unsaturated, resulting in waste of signals in the R channel and B channel.

In the Complementary Metal-Oxide Semiconductor image sensor provided by the embodiments of this disclosure, the color filter and sub-wavelength pixel unit provided for the CIS are incorporated with light filter units and PD column units which correspond to different wavelength ranges, to select and absorb light in different wavelength ranges. In addition, the various PD column units corresponding to light of different wavelength ranges have light-receiving surfaces of equal area, but they have unequal junction area, therefore, the different PD column units corresponding to light of different wavelength ranges have different full well capacities. Accordingly, the different types of pixels can reach saturation at the same time, making full use of the information of each channel, and greatly improving the efficiency of the CIS. For example, for a CIS equipped with a RWWB array color filter, the PD columns of the various PD column units corresponding to different wavelength ranges are arranged according to different preset angles, in such a manner that the light-receiving surfaces of the R, W, and B channels that are provided by the upper surfaces of the PD columns close to the color filter have a same size, and among the junction area of the lower junction surfaces, the junction area of the W channel is the largest, and the junction area of the R channel and the junction area of the B channel are small. In this way, the full well capacity of the W channel is maximized, whereas the full well capacities of the R and B channels are small, the R, W and B channels can therefore reach saturation at the same time.

It should be noted that the type of the CIS provided in the embodiments of this disclosure may be FSI or BSI, which is not limited herein. The following embodiments are illustrated by taking BSI as an example.

The technical solutions in the embodiments of the present disclosure will be clearly and completely described below in conjunction with the drawings in the embodiments of the present disclosure.

The embodiments of the present disclosure provide a CIS. FIG. 4 is a schematic structural diagram of the CIS provided by the embodiments of the present disclosure. As shown in FIG. 4, in the embodiments of the disclosure, for a BSI-type CIS, the CIS 10 includes a color filter 11 and a sub-wavelength pixel unit 12.

It should be noted that, in the embodiments of the present disclosure, the color filter 11 includes a first light filter unit 111 corresponding to a first wavelength range, a second light filter unit 112 corresponding to a second wavelength range, and a third light filter unit 113 corresponding to a third wavelength range.

Further, in the embodiments of the present disclosure, the sub-wavelength pixel unit 12 includes a first photodiode (PD) column unit 121 corresponding to the first wavelength range, a second PD column unit 122 corresponding to the second wavelength range, and a third PD column unit 123 corresponding to the three wavelength range.

It should be noted that, in the embodiments of the present disclosure, a first light-receiving surface of the first PD column unit 121, a second light-receiving surface of the second PD column unit 122, and a third light-receiving surface of the third PD column unit 123 have equal area.

Further, in the embodiments of the present disclosure, first junction area of the first PD column unit 121, second junction area of the second PD column unit 122, and third junction area of the third PD column unit 123 are not equal.

Further, in the embodiments of the present disclosure, the first light filter unit 111 may be configured to select incident light according to the first wavelength range; the second light filter unit 112 may be configured to select the incident light according to the second wavelength range; and the third light filter unit 113 may be configured to select the incident light according to the third wavelength range.

Further, in the embodiments of the present disclosure, the color filter 11 may be composed of multiple different types of light filter units. For example, the type of the color filter 11 may be any of RWWB, RYYB, RGB, or CMY. For example, in FIG. 1, the type of the color filter 11 may be RWWB, that is, the first light filter unit 111, the second light filter unit 112, and the third light filter unit 113 of the color filter 11 may include a red filter unit, a blue filter unit, and a white filter unit.

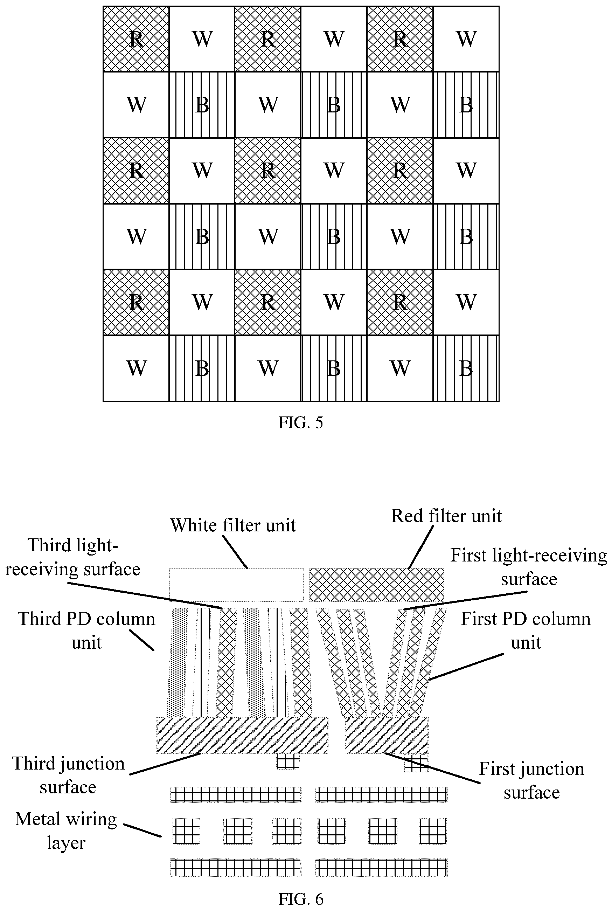

FIG. 5 is a schematic diagram of the RWWB color filter. As shown in FIG. 5, when the type of the color filter 11 is RWWB, the color filter 11 may be composed of a red filter unit, a blue filter unit and a white filter unit which are arranged in a form of R, W, W, and B.

It should be noted that, in the embodiments of the present disclosure, the red, blue and white filter units composing the color filter 11 may also be arranged in a form of W, R, B, and W, or in a form of B, W, W, and R.

Further, in the embodiments of the present disclosure, the first wavelength range may be a wavelength range of red light, the second wavelength range may be a wavelength range of blue light, and the third wavelength range may be a wavelength range of white light. In this case, the type of the corresponding color filter 11 composed by the first light filter unit 111, the second light filter unit 112 and the third light filter unit 113 may be RWWB.

Further, in the embodiments of the present disclosure, the first wavelength range may be a wavelength range of red light, the second wavelength range may be a wavelength range of blue light, and the third wavelength range may be a wavelength range of yellow light. In this case, the type of the corresponding color filter 11 composed by the first light filter unit 111, the second light filter unit 112 and the third light filter unit 113 may be RYYB.

Further, in the embodiments of the present disclosure, the first wavelength range may be a wavelength range of cyan light, the second wavelength range may be a wavelength range of magenta light, and the third wavelength range may be a wavelength range of yellow light. In this case, the type of the corresponding color filter 11 composed by the first light filter unit 111, the second light filter unit 112 and the third light filter unit 113 may be CMY.

Further, in the embodiments of the present disclosure, the first wavelength range may be a wavelength range of red light, the second wavelength range may be a wavelength range of blue light, and the third wavelength range may be a wavelength range of green light. In this case, the type of the corresponding color filter 11 composed by the first light filter unit 111, the second light filter unit 112 and the third light filter unit 113 may be RGB.

It should be noted that, in the embodiments of the present disclosure, the specific type of the color filter 11 is not limited. The embodiments shown in FIG. 4 and FIG. 5 of the present disclosure are illustrated by taking the RWWB color filter as an example.

Further, in the embodiments of the present disclosure, the color filter 11 may further include a substrate 114. Specifically, the first light filter unit 111 is arranged on the substrate according to first area, the second light filter unit 112 arranged on the substrate according to second area, and the third light filter unit 113 is arranged on the substrate according to third area.

It should be noted that, in the embodiments of the present disclosure, the substrate 114 may include a first region, a second region, and a third region. The first light filter unit 111 may be arranged in the first region of the substrate 114. The second light filter unit 112 may be arranged in the second region of the substrate 114. The third light filter unit 113 may be arranged in the third region of the substrate 114. The area of the first region may be determined as the first area, the area of the second region may be determined as the second area, and the area of the third region may be determined as the third area.

Further, in the embodiments of the present disclosure, when the first wavelength range is a wavelength range of red light, the second wavelength range is a wavelength range of blue light, and the third wavelength range is a wavelength range of white light or yellow light, that is, when the type of he color filter 11 is RWWB or RYYB, the ratio of the first area, the second area and the third area may be 1:1:2. For example, in RWWB, the area of the first region occupied by the red filter unit may account for 25% of the area of the substrate 114, the area of the second region occupied by the blue filter unit may account for 25% of the area of the substrate 114, and the area of the third region occupied by the white filter unit, that is, a region where no light filtering is performed, may account for 50% of the area of the substrate 114.

Further, in the embodiments of the present disclosure, when the first wavelength range is a wavelength range of cyan light, the second wavelength range is a wavelength range of magenta light, and the third wavelength range is a wavelength range of yellow light, that is, when the type of the color filter 11 is CMY, the ratio of the first area, the second area and the third area may be 1:1:1. For example, in CMY, the area of the first region occupied by the cyan filter unit may account for 1/3 of the area of the substrate 114, the area of the second region occupied by the magenta filter unit may account for 1/3 of the area of the substrate 114, and the area of the third region occupied by the yellow filter unit may account for 1/3 of the area of the substrate 114.

It should be noted that, in the embodiments of the present disclosure, through optical resonance, the first PD column unit 121, the second PD column unit 122, and the third PD column unit 123 may absorb and convert the incident light according to the respective wavelength ranges to obtain an electric signal corresponding to the incident light.

Further, in the embodiments of the present disclosure, the first PD column unit 121 is configured to absorb the incident light according to the first wavelength range, the second PD column unit 122 is configured to absorb the incident light according to the second wavelength range, and the third PD column unit 123 is configured to absorb the incident light according to the third wavelength range. For example, the first PD column unit 121 may absorb the red light in the incident light according to the first wavelength range, the second PD column unit 122 may absorb the blue light in the incident light according to the second wavelength range, and the third PD column unit 123 may absorb all the incident light according to the third wavelength range.

It should be noted that, in the embodiments of the present disclosure, the PD columns of the first PD column unit 121, the second PD column unit 122, and the third PD column unit 123 have different sizes. Specifically, the size of each PD column of the first PD column unit 121 may be determined according to the first wavelength range, the size of each PD column of the second PD column unit 122 may be determined according to the second wavelength range, and the size of each PD column of the third PD column unit 123 may be determined according to the third wavelength range. The size of each PD column may include a diameter and a height. Since the sub-wavelength pixel unit 12 includes the first PD column unit 121, the second PD column unit 122, and the third PD column unit 123 which have PD columns of different sizes, the sub-wavelength pixel unit 12 can simultaneously absorb light of different colors from the incident light through the optical resonance. Compared with the related art, the quantum efficiency of the CIS is greatly improved.

Further, in the embodiments of the present disclosure, the diameter of each PD column may be determined by the wavelength of the respective light that it absorbs. For example, when the first PD column unit 121 is configured to absorb red light, it may be determined, according to the wavelength of the red light, that the first PD column unit 121 includes PD columns having a diameter of 120 nm. When the second PD column unit 122 is configured to absorb blue light, it may be determined, according to the wavelength of the blue light, that the second PD column unit 122 includes PD columns having a diameter of 60 nm. When the third PD column unit 123 is configured to absorb white light, it may be determined, according to the wavelength of the white light, that the third PD column unit 123 includes PD columns having a diameter of 60 nm, PD columns having a diameter of 90 nm, and PD columns having a diameter of 120 nm. Specifically, since the third PD column unit is configured to absorb white light, the third PD column unit may include PD columns having a diameter of 120 nm for absorbing the red light, PD columns having a diameter of 60 nm for absorbing the blue light, and PD columns having a diameter of 90 nm for absorbing green light; as such, the effect of absorbing white light can be provided by the third PD column unit.

It should be noted that, in the embodiments of the present disclosure, the height of each PD column may be determined according to the wavelength of the respective light that it absorbs and the refractive index of the lens. Specifically, the height of each PD column may be in a range from 100 nm to 2 µm.

In the embodiments of the present disclosure, the various PD columns in the sub-wavelength pixel unit 12 are arranged according to different preset angles, so as to ensure that the first light-receiving surface of the first PD column unit 121, the second light-receiving surface of the two PD column unit 122 and the third light-receiving surface of the third PD column unit 123 have equal area, and meanwhile, the first junction area of the first PD column unit 121, the second junction area of the second PD column unit 122 and the third junction area of the third PD column unit 123 are not equal.

It should be noted that, in the embodiments of this disclosure, the light-receiving surface of each PD column is one of the two bottom surfaces of the PD column that is close to the color filter 11. Further, the first light-receiving surface is formed by all the light-receiving surfaces of all PD columns of the first PD column unit 121, the second light-receiving surface is formed by all the light-receiving surfaces of all PD columns of the second PD column unit 122, and the third light-receiving surface is formed by all the light-receiving surfaces of all PD columns of the third PD column unit 123.

Further, in the embodiments of the present disclosure, a junction surface of each PD column is the PN junction surface of the PD column, that is, one of the two bottom surfaces of the PD column that is away from the color filter 11. Further, the first junction area refers to the total area of the PN junction surfaces of all PD columns of the first PD column unit 121, the second junction area refers to the total area of the PN junction surfaces of all PD columns of the second PD column unit 122, and the third junction area refers to the total area of the PN junction surfaces of all PD columns of the third PD column unit 123.

It should be noted that, in the embodiments of the present disclosure, since the area of the first light-receiving surface of the first PD column unit 121, the area of the second light-receiving surface of the second PD column unit 122, and the area of the third light-receiving surface of the third PD column unit 123 are equal, and the first junction area of the first PD column unit 121, the second junction area of the second PD column unit 122, and the third junction area of the third PD column unit 123 are unequal, it is ensured that different channels correspond to different full well capacities, thereby ensuring that the various channels reach saturation at the same time.

FIG. 6 is a schematic diagram of the R channel and the W channel. As shown in FIG. 6, in the case where the first wavelength range is the wavelength range of red light and the third wavelength range is the wavelength range of white light, the PD columns of the first PD column unit 121 corresponding to the first wavelength range each are arranged at different preset angles, and the PD columns of the third PD column unit 123 corresponding to the third wavelength range each are also arranged at different preset angles, so as to ensure that the first light-receiving surface of the first PD column unit 121 and the third light-receiving surface of the third PD column unit 123 have equal area. In addition, it can also be ensured that the first junction area of the first PD column unit 121 and the third junction area of the third PD column unit 123 are unequal. It should be noted that, for the R channel, it only has PD columns with the same diameter, that is, the first PD column unit 121 is configured to only absorb the red light; in addition, the first PD column unit 121 is configured to gradually narrow from top to bottom, accordingly, the area of the first light-receiving surface is larger than the first junction area. For the W channel, it has PD columns with different diameters for respectively absorbing three types of light, i.e., red, green and blue light (in which blue light corresponds to PD columns with a diameter of about 60 nm, green light corresponds to PD columns with a diameter of about 90 nm, and red light corresponds to PD columns with a diameter of about 120 nm). These columns absorb the red light, green light and blue light, respectively, so as to achieve the effect of absorbing white light. The third PD column unit 123 is configured to gradually widen from top to bottom, and accordingly, the area of the third light-receiving surface is smaller than the third junction area. As mentioned above, the area of the light-receiving surfaces of the R channel is equal to the area of the light-receiving surfaces of the W channel, and the third junction area of the PN junction of the W channel is larger than the first junction area of the PN junction of the R channel.

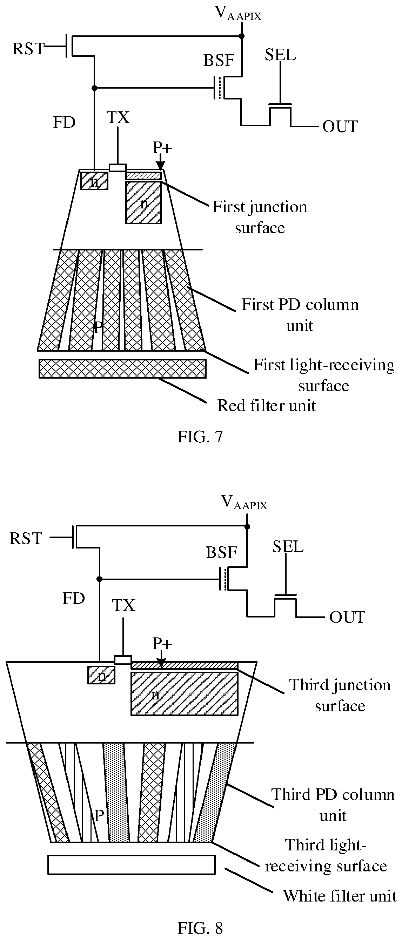

Based on FIG. 6, FIG. 7 illustrates a schematic diagram of a circuit of the R channel, and FIG. 8 illustrates a schematic diagram of a circuit of the W channel. As shown in FIG. 7 and FIG. 8, under the equal area of the light-receiving surfaces, the full well capacity of the W channel is larger than the full well capacity of the R channel. This ensures that the full well capacity of the W channel is much larger than the full well capacity of the R channel. That is, the various PD columns in the sub-wavelength pixel unit 12 are arranged at different preset angles, in such a manner that the W channel and the R channel can reach saturation at the same time. Specifically, the ratio of the full well capacity between the W channel and the R channel can be determined according to the ratio of the amount of light into the W channel to the amount of light into the R channel. Furthermore, the same design is also applicable to the PD columns for the B channel in RWWB.

Further, in the embodiments of the present disclosure, when the first wavelength range is the wavelength range of red light, the second wavelength range is the wavelength range of blue light, and the third wavelength range is the wavelength range of white light or yellow light, that is, when the type of the color filter 11 is RWWB or RYYB, the first junction area of the first PD column unit 121 corresponding to the first wavelength range is smaller than the third junction area of the third PD column unit 123 corresponding to the third wavelength range, and meanwhile, the second junction area of the second PD column unit 122 corresponding to the second wavelength range is also smaller than the third junction area.

It should be noted that, in the embodiments of the present disclosure, when the first wavelength range is the wavelength range of red light, the second wavelength range is the wavelength range of blue light, and the third wavelength range is the wavelength range of white light or yellow light, that is, when the type of the color filter 11 is RWWB or RYYB, since the first light-receiving surface of the first PD column unit 121 corresponding to the first wavelength range, the second light-receiving surface of the second PD column unit 122 corresponding to the second wavelength range, and the third light receiving surface of the third PD column unit 123 corresponding to the third wavelength range have equal area, and both the first junction area and the second function area are smaller than the third junction area, the area of the first light-receiving surface is larger than the first junction area, the area of the second light-receiving surface is larger than the second junction area, and the area of the third light-receiving surface is smaller than the third junction area.

In the embodiments of the present disclosure, based on FIG. 4, the CIS 10 may further include a semiconductor substrate 13, a readout circuit 14 and an image processor 15.

It should be noted that, in the embodiments of the present disclosure, the sub-wavelength pixel unit 12 is arranged in the semiconductor substrate 13. The sub-wavelength pixel unit 12 is configured to sense the incident light.

Further, in the embodiments of the present disclosure, the sub-wavelength pixel unit 12 is connected with the readout circuit 14, and the readout circuit 14 is in turn connected with the image processor 15. Therefore, the electrical signal obtained by converting the incident light can be transmitted from the sub-wavelength pixel unit 12 to the readout circuit 14 and then processed by the image processor 15.

Further, in the embodiments of the present disclosure, the color filter 11 is configured to select the incident light through the first light filter unit 111, the second light filter unit 112, and the third light filter unit 113.

Further, in the embodiments of the present disclosure, the sub-wavelength pixel unit 12 is configured to convert, through the first PD column unit 121, the second PD column unit 122, and the third PD column unit 123, the incident light into the electrical signal, and transmit the electrical signal to the readout circuit 14.

The readout circuit 14 is configured to convert the electrical signal into a digital signal to obtain primary data, and transmit the primary data to the image processor 15.

The image processor 15 is configured to generate, according to the primary data, an image corresponding to the incident light.

Further, in the embodiments of the present disclosure, the CIS 10 further includes a lens 16. The lens 16 is connected with the color filter 11. Specifically, the lens 16 is configured to focus the incident light.

Further, in the embodiments of the present disclosure, the shape of each PD column of the first PD column unit 121, the second PD column unit 122, and the third PD column unit 123 may be one selected from of a rectangular parallelepiped, a cylinder, and a parallelogram. The specific shape thereof can be selected according to the actual situation, which is not limited herein.

It should be noted that, in the embodiments of the present disclosure, the pixel size corresponding to the sub-wavelength pixel unit 12 is smaller than any one of the first wavelength range, the second wavelength range, and the third wavelength range.

Further, in the embodiments of this disclosure, a sub-wavelength structure refers to a periodic (or aperiodic) structure with a feature size equal to or smaller than the working wavelength. The sub-wavelength structure has a feature size smaller than the wavelength, and its reflectance, transmittance, polarization characteristics, and spectral characteristics all show completely different characteristics from related diffractive optical elements, and therefore the sub-wavelength structure has greater application potential. So far, it is mainly used as anti-reflection surface, polarizing device, narrow band filter, phase plate and the like. The general sub-wavelength anti-reflection microstructure is a sub-wavelength grating with a relief structure. By adjusting the material of the grating and structural parameters, such as groove depth, duty cycle and period, the grating can have almost zero reflectivity.

It should be noted that, in the embodiments of this disclosure, the lens 15 is configured to focus the incident light. Since the CIS in this disclosure can selectively absorb light of different wavelengths from the incident light through the sub-wavelength pixel unit composed of the PD columns of different sizes, the optical density can be enhanced locally; in this case, the lens 15 in the CIS 10 can also be omitted. That is, the lens 15 is not necessary in the CIS 10 provided by the embodiments of the present disclosure. The provision of the lens can be made according to the actual situation, which is not limited herein.

It should be noted that, the type of the CIS 10 provided by the embodiments of this disclosure may be FSI or BSI. The embodiments of this disclosure are illustrated by taking BSI as an example, but this is not limited herein.

The embodiments of this disclosure provide a Complementary Metal-Oxide Semiconductor image sensor. The CIS includes a color filter and a sub-wavelength pixel unit. The color filter includes a first light filter unit corresponding to a first wavelength range, a second light filter unit corresponding to a second wavelength range, and a third light filter unit corresponding to a third wavelength range. The sub-wavelength pixel unit includes a first photodiode (PD) column unit corresponding to the first wavelength range, a second PD column unit corresponding to the second wavelength range, and a third PD column unit corresponding to the third wavelength range. A first light-receiving surface of the first PD column unit, a second light-receiving surface of the second PD column unit, and a third light-receiving surface of the third PD column unit have equal area. First junction area of the first PD column unit, second junction area of the second PD column unit, and third junction area of the third PD column unit are not equal. As can be seen, in the embodiments of the present disclosure, the color filter and sub-wavelength pixel unit provided for the CIS are incorporated with light filter units and PD column units which correspond to different wavelength ranges, to select and absorb light in different wavelength ranges. In addition, the various PD column units corresponding to light of different wavelength ranges have light-receiving surfaces of equal area, but they have unequal junction area, therefore, the different PD column units corresponding to light of different wavelength ranges have different full well capacities. Accordingly, the different types of pixels can reach saturation at the same time, making full use of the information of each channel, and greatly improving the efficiency of the CIS.

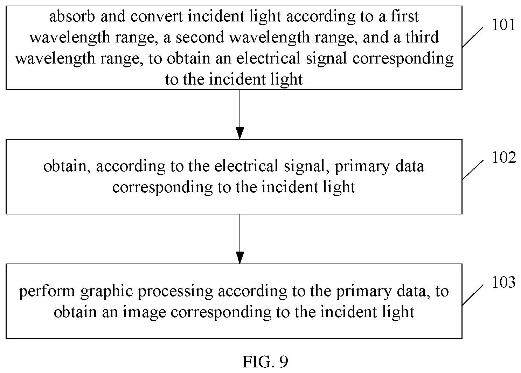

Based on the foregoing embodiments, in further embodiments of the present disclosure, an image processing method is provided, which is shown in FIG. 9. The image processing method is applied to a CIS. As shown in FIG. 9, the image processing method applied to the CIS includes operations as follows.

At block 101, incident light is absorbed and converted according to a first wavelength range, a second wavelength range, and a third wavelength range, to obtain an electrical signal corresponding to the incident light.

In the embodiments of the present disclosure, the CIS may first absorb and convert the incident light according to the first wavelength range, the second wavelength range, and the third wavelength range, so as to obtain the electrical signal corresponding to the incident light.

It should be noted that, in the embodiments of this disclosure, the CIS may include a color filter, a semiconductor substrate, a sub-wavelength pixel unit, and a readout circuit. Among them, the sub-wavelength pixel unit is arranged in the semiconductor substrate. The sub-wavelength pixel unit can be used to sense the incident light, and the sub-wavelength pixel unit is connected with the readout circuit. In this way, the electrical signal obtained by converting the incident light can be transmitted from the sub-wavelength pixel unit to the readout circuit.

It should be noted that, in the embodiments of the present disclosure, the color filter includes a first light filter unit corresponding to the first wavelength range, a second light filter unit corresponding to the second wavelength range, and a third light filter unit corresponding to the third wavelength range.

It should be noted that, in the embodiments of the present disclosure, the sub-wavelength pixel unit includes a first photodiode (PD) column unit corresponding to the first wavelength range, a second PD column unit corresponding to the second wavelength range, and a third PD column unit corresponding to the third wavelength range.

It should be noted that, in the embodiments of the present disclosure, a first light-receiving surface of the first PD column unit, a second light-receiving surface of the second PD column unit, and a third light-receiving surface of the third PD column unit have equal area.

Further, in the embodiments of the present disclosure, first junction area of the first PD column unit, second junction area of the second PD column unit, and third junction area of the third PD column unit are not equal.

It should be noted that, in the embodiments of the present disclosure, the color filter may be composed of different types of light filter units. For example, the type of the color filter may be any of RWWB, RYYB, RGB, or CMY.

Further, in the embodiments of the present disclosure, the first PD column unit is configured to absorb the incident light according to the first wavelength range, the second PD column unit is configured to absorb the incident light according to the second wavelength range, and the third PD column unit is configured to absorb the incident light according to the third wavelength range. For example, the first PD column unit may absorb the red light in the incident light according to the first wavelength range, the second PD column unit may absorb the blue light in the incident light according to the second wavelength range, and the third PD column unit may absorb all the incident light according to the third wavelength range.

It should be noted that in the embodiments of the present disclosure, the PD columns of the first PD column unit, the second PD column unit, and the third PD column unit have different sizes. Specifically, the size of each PD column of the first PD column unit may be determined according to the first wavelength range, the size of each PD column of the second PD column unit may be determined according to the second wavelength range, and the size of each PD column of the third PD column unit may be determined according to the third wavelength range. The size of each PD column may include a diameter and a height. Since the sub-wavelength pixel unit includes the first PD column unit, the second PD column unit, and the third PD column unit which have PD columns of different sizes, the sub-wavelength pixel unit can simultaneously absorb light of different colors from the incident light through the optical resonance. Compared with the related art, the quantum efficiency of the CIS is greatly improved.

Further, in the embodiments of the present disclosure, the diameter of each PD column may be determined by the wavelength of the respective light that it absorbs. For example, when the first PD column unit is configured to absorb red light, it may be determined, according to the wavelength of the red light, that the first PD column unit includes PD columns having a diameter of 120 nm. When the second PD column unit is configured to absorb blue light, it may be determined, according to the wavelength of the blue light, that the second PD column unit includes PD columns having a diameter of 60 nm. When the third PD column unit is configured to absorb white light, it may be determined, according to the wavelength of the white light, that the third PD column unit includes PD columns having a diameter of 60 nm, PD columns having a diameter of 90 nm, and PD columns having a diameter of 120 nm. Specifically, since the third PD column unit is configured to absorb white light, the third PD column unit may include PD columns having a diameter of 120 nm for absorbing the red light, PD columns having a diameter of 60 nm for absorbing the blue light, and PD columns having a diameter of 90 nm for absorbing green light; as such, the effect of absorbing white light can be provided by the third PD column unit.

It should be noted that, in the embodiments of the present disclosure, the height of each PD column may be determined according to the wavelength of the respective light that it absorbs and the refractive index of the lens. Specifically, the height of each PD column may be in a range from 100 nm to 2 µm.

Further, in the embodiments of the present disclosure, the various PD columns in the sub-wavelength pixel unit are arranged according to different preset angles, so as to ensure that the first light-receiving surface of the first PD column unit, the second light-receiving surface of the second PD column unit and the third light-receiving surface of the third PD column unit have equal area, and meanwhile, the first junction area of the first PD column unit, the second junction area of the second PD column unit and the third junction area of the third PD column unit are not equal.

It should be noted that, in the embodiments of this disclosure, the light-receiving surface of each PD column is one of the two bottom surfaces of the PD column that is close to the color filter. Further, the first light-receiving surface is formed by all the light-receiving surfaces of all PD columns of the first PD column unit, the second light-receiving surface is formed by all the light-receiving surfaces of all PD columns of the second PD column unit, and the third light-receiving surface is formed by all the light-receiving surfaces of all PD columns of the third PD column unit.

Further, in the embodiments of the present disclosure, the junction surface of each PD column is the PN junction surface of the PD column, that is, one of the two bottom surfaces of the PD column that is away from the color filter. Further, the first junction area refers to the total area of the PN junction surfaces of all PD columns of the first PD column unit, the second junction area refers to the total area of the PN junction surfaces of all PD columns of the second PD column unit, and the third junction area refers to the total area of the PN junction surfaces of all PD columns of the third PD column unit.

It should be noted that, in the embodiments of the present disclosure, since the area of the first light-receiving surface of the first PD column unit, the area of the second light-receiving surface of the second PD column unit, and the area of the third light-receiving surface of the third PD column unit are equal, and the first junction area of the first PD column unit, the second junction area of the second PD column unit, and the third junction area of the third PD column unit are unequal, it is ensured that different channels correspond to different full well capacities, thereby ensuring that the various channels reach saturation at the same time.

At block 102, primary data corresponding to the incident light is obtained according to the electrical signal.

In the embodiments of this disclosure, after the sub-wavelength pixel unit in the CIS converts the incident light into the electrical signal through the first PD column unit, the second PD column unit, and the third PD column unit, the electrical signal can be transmitted to the readout circuit. The readout circuit can convert the electrical signal into a digital signal, to obtain the primary data.

At block 103, graphic processing is performed according to the primary data, to obtain an image corresponding to the incident light.

In the embodiments of this disclosure, the CIS may also include an image processor. The image processor is connected with the readout circuit. After the CIS obtains, according to the electrical signal, the primary data corresponding to the incident light, the readout circuit can transmit the primary data to the image processor. The image processor can perform graphic processing according to the primary data, to obtain the image corresponding to the incident light.

In the embodiments of the present disclosure, the CIS may further include a lens. The lens is connected with the color filter, and is configured to focus the incident light. Specifically, since the CIS in this disclosure can selectively absorb light of different wavelengths from the incident light through the sub-wavelength pixel unit composed of the PD columns of different sizes, the optical density can be enhanced locally; in this case, the lens in the CIS can also be omitted. That is, the lens is not necessary in the CIS provided by the embodiments of the present disclosure. The provision of the lens can be made according to the actual situation, which is not limited herein.

The embodiments of this disclosure provide an image processing method applied to a CIS. The CIS includes a color filter and a sub-wavelength pixel unit. The color filter includes a first light filter unit corresponding to a first wavelength range, a second light filter unit corresponding to a second wavelength range, and a third light filter unit corresponding to a third wavelength range. The sub-wavelength pixel unit includes a first photodiode (PD) column unit corresponding to the first wavelength range, a second PD column unit corresponding to the second wavelength range, and a third PD column unit corresponding to the third wavelength range. A first light-receiving surface of the first PD column unit, a second light-receiving surface of the second PD column unit, and a third light-receiving surface of the third PD column unit have equal area. First junction area of the first PD column unit, second junction area of the second PD column unit, and third junction area of the third PD column unit are not equal. As can be seen, in the embodiments of the present disclosure, the color filter and sub-wavelength pixel unit provided for the CIS are incorporated with light filter units and PD column units which correspond to different wavelength ranges, to select and absorb light in different wavelength ranges. In addition, the various PD column units corresponding to light of different wavelength ranges have light-receiving surfaces of equal area, but they have unequal junction area, therefore, the different PD column units corresponding to light of different wavelength ranges have different full well capacities. Accordingly, the different types of pixels can reach saturation at the same time, making full use of the information of each channel, and greatly improving the efficiency of the CIS.

Based on the foregoing embodiments, in further embodiments of the present disclosure, a computer-readable storage medium is provided, which has a program stored thereon. The program, when being executed by a processor, causes the processor to implement the image processing method described above.

Specifically, program instructions corresponding to the image processing method in the embodiments can be stored on a storage medium, such as an optical disk, hard disk, USB flash drive and the like. When the program instructions corresponding to the image processing method that are stored in the storage medium are read or executed by an electronic device, the following operations are performed:
absorbing and converting incident light according to a first wavelength range, a second wavelength range, and a third wavelength range, to obtain an electrical signal corresponding to the incident light;
obtaining primary data corresponding to the incident light, according to the electrical signal; and
performing graphic processing according to the primary data, to obtain an image corresponding to the incident light.

Those skilled in the art should understand that the embodiments of the present disclosure can be embodied as a method, a display, or a computer program product. Therefore, this disclosure may be embodied in hardware, software, or a combination of software and hardware. Moreover, this disclosure may be embodied as a computer program product implemented on one or more computer-readable storage media (including but not limited to a disk storage, an optical storage, etc.) containing computer-readable program codes.

This disclosure is described with reference to the schematic diagrams and/or block diagrams of the implementation process of the methods, device (system), and computer program products according to the embodiments of the disclosure. It should be understood that each process and/or block in the schematic flow chart and/or block diagram can be realized by computer program instructions, and a combination of processes and/or blocks in the schematic flow chart and/or block diagram can be realized by computer program instructions. These computer program instructions can be provided to the processor of a general-purpose computer, a special-purpose computer, an embedded processor, or other programmable data processing devices to generate a machine, so that the instructions executed by the processor of the computer or other programmable data processing devices produce an apparatus for implementing functions specified in one or more processes in the schematic flow chart and/or one or more blocks in the block diagram.

These computer program instructions can also be stored in a computer-readable memory that can direct a computer or other programmable data processing devices to work in a specific manner, so that the instructions stored in the computer-readable memory produce an article including the instruction apparatus, where the instruction apparatus realizes the functions specified in one or more processes in the schematic flow chart and/or one or more blocks in the block diagram.

These computer program instructions can also be loaded on a computer or other programmable data processing devices, so that a series of operation steps are executed on the computer or other programmable devices to produce computer-implemented processing, so that the instructions executed on the computer or other programmable devices provide operations for implementing functions specified in one or more processes in the schematic flow chart and/or one or more blocks in the block diagram.

The foregoing are only preferred embodiments of the present disclosure, and are not used to limit the protection scope of the present disclosure.

### INDUSTRIAL APPLICABILITY

The embodiments of the disclosure provide a Complementary Metal-Oxide Semiconductor image sensor, an image processing method, and a storage medium. The CIS includes a color filter and a sub-wavelength pixel unit. The color filter includes a first light filter unit corresponding to a first wavelength range, a second light filter unit corresponding to a second wavelength range, and a third light filter unit corresponding to a third wavelength range. The sub-wavelength pixel unit includes a first PD column unit corresponding to the first wavelength range, a second PD column unit corresponding to the second wavelength range, and a third PD column unit corresponding to the third wavelength range. A first light-receiving surface of the first PD column unit, a second light-receiving surface of the second PD column unit, and a third light-receiving surface of the third PD column unit have equal area. First junction area of the first PD column unit, second junction area of the second PD column unit, and third junction area of the third PD column unit are not equal. As can be seen, in the embodiments of the present disclosure, the color filter and sub-wavelength pixel unit provided for the CIS are incorporated with light filter units and PD column units which correspond to different wavelength ranges, to select and absorb light in different wavelength ranges. In addition, the various PD column units corresponding to light of different wavelength ranges have light-receiving surfaces of equal area, but they have unequal junction area, therefore, the different PD column units corresponding to light of different wavelength ranges have different full well capacities. Accordingly, the different types of pixels can reach saturation at the same time, making full use of the information of each channel, and greatly improving the efficiency of the CIS.

## Claims

1. A Complementary Metal-Oxide Semiconductor image sensor, CIS, (10), comprising:
a color filter (11) comprising a first light filter unit (111) corresponding to a first wavelength range, a second light filter unit (112) corresponding to a second wavelength range, and a third light filter unit (113) corresponding to a third wavelength range; and
a sub-wavelength pixel unit (12) comprising a first photodiode, PD, column unit (121) corresponding to the first wavelength range, a second PD column unit (122) corresponding to the second wavelength range, and a third PD column unit (123) corresponding to the third wavelength range;
wherein
a first light-receiving surface of the first PD column unit (121), a second light-receiving surface of the second PD column unit (122), and a third light-receiving surface of the third PD column unit (123) have equal area; and first junction area of the first PD column unit (121), second junction area of the second PD column unit (122), and third junction area of the third PD column unit (123) are unequal;
each of the first PD column unit (121), the second PD column unit (122), and the third PD column unit (123) comprises a plurality of PD columns, and the PD columns in the sub-wavelength pixel unit (12) are arranged according to different preset angles;
the first light-receiving surface is formed by light-receiving surfaces of all the PD columns of the first PD column unit (121), the second light-receiving surface is formed by light-receiving surfaces of all the PD columns of the second PD column unit (122), the third light-receiving surface is formed by light-receiving surfaces of all the PD columns of the third PD column unit (123), and the light-receiving surface of each PD column is one surface of the PD column that is close to the color filter (11); and
the first junction area is total area of PN junction surfaces of all the PD columns of the first PD column unit (121), the second junction area is total area of PN junction surfaces of all the PD columns of the second PD column unit (122), the third junction area is total area of PN junction surfaces of all the PD columns of the third PD column unit (123), and the PN junction surface of each PD column is one surface of the PD column that is away from the color filter (11).

2. The CIS (10) as claimed in claim 1, wherein the color filter (11) further comprises a substrate (114) comprising:
a first region of the substrate (114) in which the first light filter unit (111) is arranged, a second region of the substrate (114) in which the second light filter unit (112) is arranged, and a third region of the substrate (114) in which the third light filter unit (113) is arranged,
wherein an area of the first region is determined as a first area, an area of the second region is determined as a second area, and an area of the third region is determined as a third area.

3. The CIS (10) as claimed in claim 2, wherein when the first wavelength range is a wavelength range of red light, the second wavelength range is a wavelength range of blue light, and the third wavelength range is a wavelength range of white light or yellow light, a ratio of the first area, the second area and the third area is 1:1:2.

4. The CIS (10) as claimed in claim 3, wherein
the first junction area is smaller than the third junction area, and the second junction area is smaller than the third junction area.

5. The CIS (10) as claimed in claim 3, wherein
the area of the first light-receiving surface is greater than the first junction area;
the area of the second light-receiving surface is greater than the second junction area; and
the area of the third light-receiving surface is smaller than the third junction area.

6. The CIS (10) as claimed in claim 2, wherein when the first wavelength range is a wavelength range of cyan light, the second wavelength range is a wavelength range of magenta light, and the third wavelength range is a wavelength range of yellow light, a ratio of the first area, the second area, and the third area is 1:1:1.

7. The CIS (10) as claimed in any of claims 1 to 6, wherein
a diameter of each of the PD columns of the first PD column unit (121) is determined according to the first wavelength range, a diameter of each of the PD columns of the second PD column unit (122) is determined according to the second wavelength range, and a diameter of each of the PD columns of the third PD column unit (123) is determined according to the third wavelength range.

8. The CIS (10) as claimed in any of claims 1 to 7, wherein the CIS (10) further comprises:
a semiconductor substrate (13) in which the sub-wavelength pixel unit (12) is arranged;
a readout circuit (14) connected with the sub-wavelength pixel unit (12); and
an image processor (15) connected with the readout circuit (14);
wherein the color filter (11) is configured to select incident light through the first light filter unit (111), the second light filter unit (112), and the third light filter unit (113);
the sub-wavelength pixel unit (12) is configured to convert, through the first PD column unit (121), the second PD column unit (122) and the third PD column unit (123), the incident light into an electrical signal, and transmit the electrical signal to the readout circuit (14);
the readout circuit (14) is configured to convert the electrical signal into a digital signal to obtain primary data, and transmit the primary data to the image processor (15); and
the image processor (15) is configured to generate, according to the primary data, an image corresponding to the incident light.

9. The CIS (10) as claimed in any of claims 1 to 8, wherein
a shape of each of the PD columns of the first PD column unit (121), the second PD column unit (122), and the third PD column unit (123) is one selected from a rectangular parallelepiped, a cylinder, and a parallelogram.

10. The CIS (10) as claimed in any of claims 1 to 9, wherein a pixel size corresponding to the sub-wavelength pixel unit (12) is smaller than any one of the first wavelength range, the second wavelength range, and the third wavelength range.

11. The CIS (10) as claimed in claim 8, wherein the CIS (10) further comprises a lens (16) connected with the color filter (11); and
the lens (16) is configured to focus the incident light.

12. The CIS (10) as claimed in claim 11, wherein a height of each of the PD columns of the first PD column unit (121) is determined according to the first wavelength range and a refractive index of the lens (16), a height of each of the PD columns of the second PD column unit (122) is determined according to the second wavelength range and the refractive index of the lens (16), and a height of each of the PD columns of the third PD column unit (123) is determined according to the third wavelength range and the refractive index of the lens (16).

13. An image processing method for the CIS (10) as claimed in any one of claims 1 to 12, the method comprising:
absorbing and converting (101), through the sub-wavelength pixel unit (12), incident light according to the first wavelength range, the second wavelength range, and the third wavelength range, to obtain an electrical signal corresponding to the incident light;
obtaining (102), according to the electrical signal, primary data corresponding to the incident light; and
performing (103) graphic processing according to the primary data, to obtain an image corresponding to the incident light.

14. A computer-readable storage medium having a program stored thereon, wherein the computer-readable storage medium is implemented in the CIS (10) as claimed in any one of claims 1 to 12, and the program, when being executed by a processor, causes the processor to implement the method as claimed in claim 13.

## Patentansprüche

1. Komplementärer Metalloxid-Halbleiterbildsensor, CIS (10), umfassend:
ein Farbfilter (11), umfassend eine erste Lichtfiltereinheit (111), die einem ersten Wellenlängenbereich entspricht, eine zweite Lichtfiltereinheit (112), die einem zweiten Wellenlängenbereich entspricht, und eine dritte Lichtfiltereinheit (113), die einem dritten Wellenlängenbereich entspricht, und
eine Subwellenlängenpixeleinheit (12), umfassend eine erste Photodioden, PD, Spalteneinheit (121), die dem ersten Wellenlängenbereich entspricht, eine zweite PD-Spalteneinheit (122), die dem zweiten Wellenlängenbereich entspricht, und eine dritte PD-Spalteneinheit (123), die dem dritten Wellenlängenbereich entspricht; wobei
eine erste lichtempfangende Oberfläche der ersten PD-Spalteneinheit (121), eine zweite lichtempfangende Oberfläche der zweiten PD-Spalteneinheit (122), und eine dritte lichtempfangende Oberfläche der dritten PD-Spalteneinheit (123) die gleiche Fläche haben; und die erste Kontaktstellenfläche der ersten PD-Spalteneinheit (121), zweite Kontaktstellenfläche der zweiten PD-Spalteneinheit (122) und dritte Kontaktstellenfläche der dritten PD-Spalteneinheit (123) ungleich sind;
jede der ersten PD-Spalteneinheit (121), der zweiten PD-Spalteneinheit (122) und der dritten PD-Spalteneinheit (123) eine Vielzahl von PD-Spalten umfasst, und die PD-Spalten in der Subwellenlängenpixeleinheit (12) gemäß unterschiedlichen vorgewählten Winkeln angeordnet sind;
die erste lichtempfangende Oberfläche durch lichtempfangende Oberflächen von allen der PD-Spalten der ersten PD-Spalteneinheit (121) gebildet wird, die zweite lichtempfangende Oberfläche durch lichtempfangende Oberflächen von allen der PD-Spalten der zweiten PD-Spalteneinheit (122) gebildet wird, die dritte lichtempfangende Oberfläche durch lichtempfangende Oberflächen von allen der PD-Spalten der dritten PD-Spalteneinheit (123) gebildet wird, und die lichtempfangende Oberfläche von jeder PD-Spalte eine Oberfläche der PD-Spalte ist, die nahe an dem Farbfilter (11) ist; und
die erste Kontaktstellenfläche die Gesamtfläche der PN-Kontaktstellenoberflächen von allen der PD-Spalten der ersten PD-Spalteneinheit (121) ist, die zweite Kontaktstellenfläche die Gesamtfläche der PN-Kontaktstellenoberflächen von allen der PD-Spalten der zweiten PD-Spalteneinheit (122) ist, die dritte Kontaktstellenfläche die Gesamtfläche der PN-Kontaktstellenoberflächen von allen der PD-Spalten der dritten PD-Spalteneinheit (123) ist, und die PN-Kontaktstellenoberfläche von jeder PD-Spalte eine Oberfläche der PD-Spalte ist, die von dem Farbfilter (11) weg weist.

2. CIS (10) nach Anspruch 1, wobei das Farbfilter (11) des Weiteren ein Substrat (114) umfasst, umfassend:
eine erste Region des Substrats (114), in der die erste Lichtfiltereinheit (111) angeordnet ist, eine zweite Region des Substrats (114), in der die zweite Lichtfiltereinheit (112) angeordnet ist, und eine dritte Region des Substrats (114), in der die dritte Lichtfilterregion (113) angeordnet ist,
wobei eine Fläche der ersten Region als eine erste Fläche bestimmt wird, eine Fläche der zweiten Region als eine zweite Fläche bestimmt wird, und eine Fläche der dritten Region als eine dritte Fläche bestimmt wird.

3. CIS (10) nach Anspruch 2, wobei, wenn der erste Wellenlängenbereich ein Wellenlängenbereich des roten Lichtes ist, der zweite Wellenlängenbereich ein Wellenlängenbereich des blauen Lichtes ist, und der dritte Wellenlängenbereich ein Wellenlängenbereich des weißen Lichtes oder gelben Lichtes ist, ein Verhältnis der ersten Fläche, der zweiten Fläche und der dritten Fläche 1:1:2 beträgt.

4. CIS (10) nach Anspruch 3, wobei die erste Kontaktstellenfläche kleiner als die dritte Kontaktstellenfläche ist, und die zweite Kontaktstellenfläche kleiner als die dritte Kontaktstellenfläche ist.

5. CIS (10) nach Anspruch 3, wobei
die Fläche der ersten lichtempfangenden Oberfläche größer als die erste Kontaktstellenfläche ist;
die Fläche der zweiten lichtempfangenden Oberfläche größer als die zweite Kontaktstellenfläche ist; und
die Fläche der dritten lichtempfangenden Oberfläche kleiner als die dritte Kontaktstellenfläche ist.

6. CIS (10) nach Anspruch 2, wobei, wenn der erste Wellenlängenbereich ein Wellenlängenbereich des cyanfarbenen Lichtes ist, der zweite Wellenlängenbereich ein Wellenlängenbereich des magentafarbenen Lichtes ist, und der dritte Wellenlängenbereich ein Wellenlängenbereich des gelben Lichtes ist, ein Verhältnis der ersten Fläche, der zweiten Fläche und der dritten Fläche 1:1:1 beträgt.

7. CIS (10) nach einem der Ansprüche 1 bis 6, wobei ein Durchmesser von jeder der PD-Spalten der ersten PD-Spalteneinheit (121) gemäß dem ersten Wellenlängenbereich bestimmt wird, ein Durchmesser von jeder der PD-Spalten der zweiten PD-Spalteneinheit (122) gemäß dem zweiten Wellenlängenbereich bestimmt wird, und ein Durchmesser von jeder der PD-Spalten der dritten PD-Spalteneinheit (123) gemäß dem dritten Wellenlängenbereich bestimmt wird.

8. CIS (10) nach einem der Ansprüche 1 bis 7, wobei der CIS (10) des Weiteren umfasst:
ein Halbleitersubstrat (13), in dem die Subwellenlängenpixeleinheit (12) angeordnet ist;
eine Ausleseschaltung (14), die mit der Subwellenlängenpixeleinheit (12) verbunden ist; und
einen Bildprozessor (15), der mit der Ausleseschaltung (14) verbunden ist;
wobei das Farbfilter (11) ausgestaltet ist, um einfallendes Licht durch die erste Lichtfiltereinheit (111), die zweite Lichtfiltereinheit (112) und die dritte Lichtfiltereinheit (113) auszuwählen;
die Subwellenlängenpixeleinheit (12) ausgestaltet ist, um durch die erste PD-Spalteneinheit (121), die zweite PD-Spalteneinheit (122) und die dritte PD-Spalteneinheit (123) das einfallende Licht in ein elektrisches Signal zu konvertieren und das elektrische Signal an die Ausleseschaltung (14) zu übermitteln;
die Ausleseschaltung (14) ausgestaltet ist, um das elektrische Signal in ein digitales Signal zu konvertieren, um Primärdaten zu erhalten, und die Primärdaten an den Bildprozessor (15) zu übermitteln; und
der Bildprozessor (15) ausgestaltet ist, um gemäß den Primärdaten ein Bild zu generieren, das dem einfallenden Licht entspricht.

9. CIS (10) nach einem der Ansprüche 1 bis 8, wobei eine Form von jeder der PD-Spalten der ersten PD-Spalteneinheit (121), der zweiten PD-Spalteneinheit (122) und der dritten PD-Spalteneinheit (123) eine ausgewählt aus einem rechteckigen Parallelepiped, einem Zylinder und einem Parallelogramm ist.

10. CIS (10) nach einem der Ansprüche 1 bis 9, wobei eine Pixelgröße entsprechend der Subwellenlängenpixeleinheit (12) kleiner als jegliche von dem ersten Wellenlängenbereich, dem zweiten Wellenlängenbereich und dem dritten Wellenlängenbereich ist.

11. CIS (10) nach Anspruch 8, wobei der CIS (10) des Weiteren eine Linse (16) umfasst, die mit dem Farbfilter (11) verbunden ist; und
die Linse (16) ausgestaltet ist, um das einfallende Licht zu fokussieren.

12. CIS (10) nach Anspruch 11, wobei eine Höhe von jeder der PD-Spalten der ersten PD-Spalteneinheit (121) gemäß dem ersten Wellenlängenbereich und einem Brechungsindex der Linse (16) bestimmt wird, eine Höhe von jeder der PD-Spalten der zweiten PD-Spalteneinheit (122) gemäß dem zweiten Wellenlängenbereich und dem Brechungsindex der Linse (16) bestimmt wird, und eine Höhe von jeder der PD-Spalten der dritten PD-Spalteneinheit (123) gemäß dem dritten Wellenlängenbereich und dem Brechungsindex der Linse (16) bestimmt wird.

13. Bildverarbeitungsverfahren für den CIS (10) gemäß einem der Ansprüche 1 bis 12, wobei das Verfahren umfasst:
Absorbieren und Konvertieren (101) von einfallendem Licht gemäß dem ersten Wellenlängenbereich, dem zweiten Wellenlängenbereich und dem dritten Wellenlängenbereich durch die Subwellenlängenpixeleinheit (12), um ein elektrisches Signal zu erhalten, das dem einfallenden Licht entspricht;
Erhalten (102) von Primärdaten, die dem einfallenden Licht entsprechen, gemäß dem elektrischen Signal; und
Durchführen (103) von grafischer Verarbeitung gemäß den Primärdaten, um ein Bild zu erhalten, das dem einfallenden Licht entspricht.

14. Computerlesbares Speichermedium mit einem darauf gespeicherten Programm, wobei das computerlesbare Speichermedium in dem CIS (10), wie in einem der Ansprüche 1 bis 12 beansprucht, implementiert ist und das Programm, wenn es durch einen Prozessor ausgeführt wird, bewirkt, dass der Prozessor das Verfahren, wie in Anspruch 13 beansprucht, implementiert.

## Revendications

1. Capteur d'images à métal-oxyde-semi-conducteur complémentaire, CIS (10), comprenant :
un filtre coloré (11) comprenant une première unité de filtrage de la lumière (111) correspondant à une première gamme de longueurs d'onde, une deuxième unité de filtrage de la lumière (112) correspondant à une deuxième gamme de longueurs d'onde, et une troisième unité de filtrage de la lumière (113) correspondant à une troisième gamme de longueurs d'onde ; et
une unité de pixels de sous-longueurs d'onde (12) comprenant une première unité de colonnes de photodiodes, PD (121) correspondant à la première gamme de longueurs d'onde, une deuxième unité de colonnes PD (122) correspondant à la deuxième gamme de longueurs d'onde, et une troisième unité de colonnes PD (123) correspondant à la troisième gamme de longueurs d'onde ;
dans lequel
une première surface de réception de lumière de la première unité de colonnes PD (121), une deuxième surface de réception de lumière de la deuxième unité de colonnes PD (122) et une troisième surface de réception de lumière de la troisième unité de colonnes PD (123) ont une aire égale ; et une première aire de jonction de la première unité de colonnes PD (121), une deuxième aire de jonction de la deuxième unité de colonnes PD (122) et une troisième aire de jonction de la troisième unité de colonnes PD (123) sont inégales ;
la première unité de colonnes PD (121), la deuxième unité de colonnes PD (122) et la troisième unité de colonnes PD (123) comprennent chacune une pluralité de colonnes PD, et les colonnes PD dans l'unité de pixels de sous-longueurs d'onde (12) sont agencées en fonction de différents angles prédéfinis ;
la première surface de réception de lumière est formée par les surfaces de réception de lumière de toutes les colonnes PD de la première unité de colonnes PD (121), la deuxième surface de réception de lumière est formée par les surfaces de réception de lumière de toutes les colonnes PD de la deuxième unité de colonnes PD (122), la troisième surface de réception de lumière est formée par les surfaces de réception de lumière de toutes les colonnes PD de la troisième unité de colonnes PD (123), et la surface de réception de lumière de chaque colonne PD est une surface de la colonne PD qui est proche du filtre coloré (11) ; et
la première aire de jonction est l'aire totale des surfaces de jonction PN de toutes les colonnes PD de la première unité de colonnes PD (121), la deuxième aire de jonction est l'aire totale des surfaces de jonction PN de toutes les colonnes PD de la deuxième unité de colonnes PD (122), la troisième aire de jonction est l'aire totale des surfaces de jonction PN de toutes les colonnes PD de la troisième unité de colonnes PD (123), et la surface de jonction PN de chaque colonne PD est une surface de la colonne PD qui est éloignée du filtre coloré (11).

2. CIS (10) selon la revendication 1, dans lequel le filtre coloré (11) comprend en outre un substrat (114) comprenant :
une première région du substrat (114) dans laquelle la première unité de filtrage de la lumière (111) est agencée, une deuxième région du substrat (114) dans laquelle la deuxième unité de filtrage de la lumière (112) est agencée, et une troisième région du substrat (114) dans laquelle la troisième unité de filtrage de la lumière (113) est agencée,
dans lequel une aire de la première région est déterminée comme une première aire, une aire de la deuxième région est déterminée comme une deuxième aire, et une aire de la troisième région est déterminée comme une troisième aire.

3. CIS (10) selon la revendication 2 dans lequel, quand la première gamme de longueurs d'onde est une gamme de longueurs d'onde de lumière rouge, la deuxième gamme de longueurs d'onde est une gamme de longueurs d'onde de lumière bleue, et la troisième gamme de longueurs d'onde est une gamme de longueurs d'onde de lumière blanche ou de lumière jaune, une proportion de la première aire, la deuxième aire et la troisième aire est 1:1:2.

4. CIS (10) selon la revendication 3, dans lequel
la première aire de jonction est inférieure à la troisième aire de jonction, et la deuxième aire de jonction est inférieure à la troisième aire de jonction.

5. CIS (10) selon la revendication 3, dans lequel
l'aire de la première surface de réception de lumière est supérieure à la première aire de jonction ;
l'aire de la deuxième surface de réception de lumière est supérieure à la deuxième aire de jonction ; et
l'aire de la troisième surface de réception de lumière est inférieure à la troisième aire de jonction.

6. CIS (10) selon la revendication 2 dans lequel, quand la première gamme de longueurs d'onde est une gamme de longueurs d'onde de lumière cyan, la deuxième gamme de longueurs d'onde est une gamme de longueurs d'onde de lumière magenta, et la troisième gamme de longueurs d'onde est une gamme de longueurs d'onde de lumière jaune, une proportion de la première aire, la deuxième aire et la troisième aire est 1:1:1.

7. CIS (10) selon l'une quelconque des revendications 1 à 6, dans lequel
un diamètre de chacune des colonnes PD de la première unité de colonnes PD (121) est déterminé en fonction de la première gamme de longueurs d'onde, un diamètre de chacune des colonnes PD de la deuxième unité de colonnes PD (122) est déterminé en fonction de la deuxième gamme de longueurs d'onde, et un diamètre de chacune des colonnes PD de la troisième unité de colonnes PD (123) est déterminé en fonction de la troisième gamme de longueurs d'onde.

8. CIS (10) selon l'une quelconque des revendications 1 à 7, le CIS (10) comprenant en outre :
un substrat semi-conducteur (13) dans lequel l'unité de pixels de sous-longueurs d'onde (12) est agencée ;
un circuit de lecture (14) relié à l'unité de pixels de sous-longueurs d'onde (12) ; et
un processeur d'images (15) relié au circuit de lecture (14) ;
dans lequel le filtre coloré (11) est configuré pour sélectionner une lumière incidente par le biais de la première unité de filtrage de la lumière (111), la deuxième unité de filtrage de la lumière (112) et la troisième unité de filtrage de la lumière (113) ;
l'unité de pixels de sous-longueurs d'onde (12) est configurée pour convertir, par le biais de la première unité de colonnes PD (121), la deuxième unité de colonnes PD (122) et la troisième unité de colonnes PD (123), la lumière incidente en un signal électrique, et transmettre le signal électrique au circuit de lecture (14) ;
le circuit de lecture (14) est configuré pour convertir le signal électrique en un signal numérique pour obtenir des données primaires, et transmettre les données primaires au processeur d'images (15) ; et
le processeur d'images (15) est configuré pour générer, en fonction des données primaires, une image correspondant à la lumière incidente.

9. CIS (10) selon l'une quelconque des revendications 1 à 8, dans lequel
une forme de chacune des colonnes PD de la première unité de colonnes PD (121), la deuxième unité de colonnes PD (122) et la troisième unité de colonnes PD (123) en est une choisie parmi un parallélépipède rectangulaire, un cylindre, et un parallélogramme.

10. CIS (10) selon l'une quelconque des revendications 1 à 9, dans lequel une taille de pixel correspondant à l'unité de pixels de sous-longueurs d'onde (12) est inférieure à n'importe quelle gamme parmi la première gamme de longueurs d'onde, la deuxième gamme de longueurs d'onde, et la troisième gamme de longueurs d'onde.

11. CIS (10) selon la revendication 8, le CIS (10) comprenant en outre une lentille (16) reliée au filtre coloré (11) ; et
la lentille (16) étant configurée pour focaliser la lumière incidente.

12. CIS (10) selon la revendication 11, dans lequel une hauteur de chacune des colonnes PD de la première unité de colonnes PD (121) est déterminée en fonction de la première gamme de longueurs d'onde et d'un indice de réfraction de la lentille (16), une hauteur de chacune des colonnes PD de la deuxième unité de colonnes PD (122) est déterminée en fonction de la deuxième gamme de longueurs d'onde et de l'indice de réfraction de la lentille (16), et une hauteur de chacune des colonnes PD de la troisième unité de colonnes PD (123) est déterminée en fonction de la troisième gamme de longueurs d'onde et de l'indice de réfraction de la lentille (16).

13. Procédé de traitement d'images pour le CIS (10) selon l'une quelconque des revendications 1 à 12, le procédé comprenant :
l'absorption et la conversion (101), par le biais de l'unité de pixels de sous-longueurs d'onde (12), d'une lumière incidente en fonction de la première gamme de longueurs d'onde, de la deuxième gamme de longueurs d'onde et de la troisième gamme de longueurs d'onde, pour obtenir un signal électrique correspondant à la lumière incidente ;
l'obtention (102), en fonction du signal électrique, de données primaires correspondant à la lumière incidente ; et
la réalisation (103) d'un traitement graphique en fonction des données primaires, pour obtenir une image correspondant à la lumière incidente.

14. Support de stockage lisible par ordinateur sur lequel est stocké un programme, le support de stockage lisible par ordinateur étant mis en œuvre dans le CIS (10) selon l'une quelconque des revendications 1 à 12, et le programme, lorsqu'il est exécuté par un processeur, conduisant le processeur à mettre en œuvre le procédé selon la revendication 13.
